(19) Europäisches Patentamt
European Patent Office
Office européen des brevets

(11) Publication number: **0 124 944**
**B1**

# (12) EUROPEAN PATENT SPECIFICATION

(45) Date of publication of patent specification: **25.11.87**

(51) Int. Cl.$^4$: **G 01 R 19/04**, H 03 D 1/18

(21) Application number: **84200631.4**

(22) Date of filing: **03.05.84**

## (54) Peak detector.

(30) Priority: **06.05.83 NL 8301602**

(43) Date of publication of application:
**14.11.84 Bulletin 84/46**

(45) Publication of the grant of the patent:
**25.11.87 Bulletin 87/48**

(84) Designated Contracting States:
**DE FR GB NL**

(56) References cited:
**DE-B-2 233 488**
**GB-A-2 070 781**
**US-A-3 651 419**

**ELECTRONICS, vol. 49, no. 4, 19th February 1976, pages 112-113; New York, US; S. HAYES: "Video detector stores peak for minutes"**

(73) Proprietor: **N.V. Philips' Gloeilampenfabrieken**
**Groenewoudseweg 1**
**NL-5621 BA Eindhoven (NL)**

(72) Inventor: **Veehof, Johannus Chr. D.M.**
***c/o* INT. OCTROOIBUREAU B.V. Prof. Holstlaan 6**
**NL-5656 AA Eindhoven (NL)**

(74) Representative: **Groenenberg, Johannes Hendrik et al**
**INTERNATIONAAL OCTROOIBUREAU B.V. Prof. Holstlaan 6**
**NL-5656 AA Eindhoven (NL)**

**EP 0 124 944 B1**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

**Description**

The invention relates to a peak detector circuit comprising a capacitor as a storage element for storing a voltage value which is a measure of the peak value of an input voltage to be applied to the peak detector, a voltage comparator circuit having a first input for the input voltage, a second input coupled to the output of the peak detector circuit and further comprising a transistor, which has its collector coupled to a first terminal of the capacitor, its emitter to the output of the comparator circuit and which transistor has between its base and the emitter a diode in anti-parallel with the base emitter-diode, and further comprising a reset switch for discharging the capacitor.

Such a peak detector is known from the article in the magazine "Electronics" Vol. 49, Number 4, 19.2.76, p. 112—113 by S. Hayes, "video detector stores peak for minutes". This article proposes a transistor circuit in common base configuration for loading a capacitor to a peak value of a very high frequency input signal with a voltage range amplitude, which capacitor will retain that peak for some considerable time. The said circuit further comprises a reset-switch and a diode anti-parallel to the emitter-base-junction of said transistor to limit the reverse base-emitter voltage of said transistor.

To attain a good tracking of the input voltage in the loadphase of the capacitor the input voltage is fed to one terminal of a comparator and the output is fed back to the other terminal of the voltage comparator, which output is connected via a resistor to the base of said transistor. A drawback is the low slew rate, because of inter alia a resistor between the output of the comparator and the emitter of the transistor circuit. A further drawback is the lack of reset level and measuring range adjusting means.

It is the object to improve the known peak detector as to mentioned drawbacks.

A peak detector in accordance with the invention is characterized in that it has reset level means, which comprise a field effect transistor with its drain connected to the first terminal of the capacitor and with its source connected to a second voltage source E2 and measuring range adjusting means, which comprise a first voltage source E1, connected to the base of the transistor and which comprise the second voltage source E2, connected to the source of the field effect transistor. With these means it is attained that the detector can be adjusted depending on input signal conditions. With E1 the maximum signal level can be fixed and E2 determines the reset level, so the dynamic range of interest is between E1 and E2.

Further embodiments of the detector in accordance with the invention comprise voltage sources E3 or E4 for setting additional range and reset levels.

The tracking of positive or negative peaks is determined by the type of said transistor on one hand (PNP, NPN) and by the way of coupling of the input signal and the feedback-signal to the comparator on the other hand. Embodiments of the detector in accordance with the invention supply both types.

To obtain shifting of the voltage measurement range on the output side the peak detector in accordance with the invention is characterized in that both measuring range means and reset-level means further comprise a voltage source E3 connected via a resistor to a first terminal of a buffer, which is connected through a second terminal to the first terminal of the capacitor and with its output to the output of the peak detector circuit and a resistor which is connected between the output of the buffer and the first terminal of the buffer and whereby the resistor is connected between the voltage source E3 and the first terminal of the buffer. The shifting is determined by the ratio of both resistors.

Embodiments of the invention will now be described in more detail, by way of example, with reference to the drawings. In the drawings:

Fig. 1 is a block diagram of a peak detector in accordance with the invention,

Fig. 2 is a diagram associated with Fig. 1,

Fig. 3 is a diagram associated with Fig. 4,

Fig. 4 shows an other schematically embodiment,

Fig. 5 shows a practical form of a peak detector, in accordance with the invention,

Fig. 6 is a diagram associated with Fig. 5,

Fig. 7 is a diagram associated with Fig. 8,

Fig. 8 shows a different embodiment for measuring negative-going peak values,

Fig. 9 shows an embodiment for measuring positive-going peak values, and

Fig. 10 is a diagram associated with Fig. 9.

The peak detector in accordance with the invention shown in Fig. 1 comprises a transistor in common-base arrangement. The varying input signal, whose positive-going or negative-going peak value is to be measured, is applied to the input 1. The input 1 is connected to a first input 2 of a voltage comparator circuit 3, whose second input 4 is connected to a capacitor 5 which is also connected to the output 6 of the peak detector for the measure peak value and to the collector 7 of the transistor 8 whose base 9 is connected to a voltage source producing a voltage E1 on a terminal 10. The emitter 11 is connected to the output 12 of the voltage comparator circuit 3. A diode 13 is arranged in anti-parallel across the base-emitter diode. The capacitor 5 may be connected to earth, but as shown, it may alternatively be connected to terminal 14 to which a voltage source producing a voltage E2 is connected. A switch 15, represented as a FET, can reset the capacitor 5, and consequently the output 6, to a well-defined potential in the present case of value E2, in order to prepare for new peak-value measurement by means of a reset signal applied to input 16.

The diagram in Fig. 2 illustrates the operation of the peak detector shown in Fig. 1. Transistor 8 is operative only if the output 12 carries a voltage which is some tenths of a volt higher than the value E1 and if moreover, the voltage on the collector 7 and consequently that on the capacitor 5 is lower than the value E1. This means that the voltage value E2 is substantially lower than the voltage value E1, so that the measurement range for peak values will be situated between E1 and E2, as indicated in Fig. 2. If the input voltage on input 1 and hence that on input 2 increases as indicated by 17, the output 12 of the comparator 3 becomes more positive and transistor 8 is turned on, so that capacitor 5 is charged, which gives rise to an increasing voltage on input 4. After the peak 18 the voltage on inputs 1 and 2 decreases and output 12 supplies a decreasing voltage, so that transistor 8 is cut off and diode 13 is turned on to limit the voltage swing on the emitter 11. The capacitor 5 retains its voltage, so that the voltage on input 4 and output 6 is constant as a function of time, as indicated by 19 in Fig. 2. At the instant T1 resetting is effected, so that at the instant T2 a new measurement begins with a new peak value at 20. A measurement range can be set by selection of E1 and E2. It is obvious that if E2 = 0 this results in a peak detector which measures positive peak values. Alternatively, E1 may be selected to be zero, so that for a negative input signal it is possible to measure the smallest value in an absolute sense but this value is negative.

Fig. 3 indicates how with a suitable choice of the voltages E1, E2 and E4 negative-going peak values of an input signal can be measured. Again the voltages E2 and E4 may be zero, so that the highest negative peak values of an input voltage can be determined.

Fig. 4 shows a circuit arrangement by means of which the diagram of Fig. 3 can be obtained. This peak detector is substantially indentical to that shown in Fig. 1, but now there is provided a buffer amplifier 21 with a gain factor of 1 in order to transfer the voltage across the capacitor 5 to the output 6 and the input 4 substantially without leakage. Moreover, the voltage comparator circuit 3 is shown in more detail, in particular to indicate that a voltage inversion is required in order to measure negative-going peak values. For this purpose there is provided a differential amplifier 22 whose output 23 is connected to the output 12, and whose non-inverting input 24 is connected to a terminal 25 to which a voltage source providing a voltage E4 is connected. The inverting input 26 is connected to input 2 *via* a resistor 27 and to an input 4 *via* a resistor 28.

The circuit operates as follows. If the voltage on input 1 is negative-going after balancing, input 26 becomes negative relative to input 24, so that outputs 23 and 12 become positive, transistor 8 is turned on, and the charge on capacitor 5 becomes more positive. The voltage on input 4 increases, which compensates for the decrease originally occurring at input 26. This means that the circuit follows the negative-going voltage 17 in Fig. 3. At the peak 18 transistor 8 is cut off and the circuit holds the voltage value 19.

Fig. 5 shows a modified form of the peak detector of Fig. 1 in more detail. The voltage comparator circuit 3 comprises a differential amplifier with transistors 29 and 30 which are emitter-coupled to a current source 31. The collector load impedance of transistor 30 is a current source 32 which provides a high gain factor and which limits the current to transistor 8. The current mirror circuit comprising transistors Tr3 and Tr4 in Fig. 1 of the article mentioned in the introductory part may be used as an alternative. If an even higher gain factor but a smaller bandwidth is desired.

Fig. 6 shows the diagram associated with the peak detector of Fig. 5. The circuit measures positive peak values from zero volts to +5 V. The circuit is reset to zero.

So far, transistor 8 was of the PNP-type. It is also possible to form a peak detector which also measures negative-going or positive-going peak values using a transistor of the NPN-type.

Fig. 7 shows a diagram identical to the diagram of Fig. 3 but with different voltage limits of the measurement range.

Fig. 8 shows the circuit arrangement of a peak detector with which the diagram shown in Fig. 7 can be obtained and in which transistor 8 is an NPN transistor. The buffer amplifier 21 is provided with negative feedback by means of resistor 33 from the output 6 to the inverting input and resistor 34 from a terminal 35, to which a voltage source producing a voltage E3 may be connected, to the inverting input. In this respect it is important to note that the measurement range can be shifted by means of the voltage E3. If the same value R is selected for the resistors 33 and 34, the gain factor of the buffer amplifier will be two for the capacitor voltage and unity for the voltage E3. As is apparent from Fig. 7, it is now possible that E3 = 2E2, so that resetting to zero is effected and it is possible to measure negative peak voltages harring maximum values in an absolute sense.

Fig. 9 is almost identical to Fig. 4, except that transistor 8 is a NPN transistor and capacitor 5 is connected to earth instead of to terminal 14. As a result of the choice of this transistor the voltage values E1 and E2 are interchanged, as will be apparent from Fig. 3 and Fig. 10. However, a significant difference between these circuit arrangements together with associated diagrams is that the peak detector shown in Fig. 9 measures positive-going peak values, as can be seen in Fig. 10.

## Claims

1. Peak detector circuit comprising a capacitor (5) as a storage element for storing a voltage value which is a measure of the peak value of an input voltage to be applied to the peak detector, a voltage comparator circuit (3) having a first input (2) for the input voltage, a second input (4) coupled to the output (6) of the peak detector circuit, and further comprising a transistor (8), which has its collector (7) coupled to a first terminal (40) of the capacitor (5), its emitter (11) to the output of the comparator circuit (3) and which transistor (8) has between its base (9) and the emitter (11) a diode (13) in anti-parallel with the base-emitter diode, and further comprising a reset switch (15) for discharging the capacitor (5) characterized in that it has reset level means, which comprise a field effect transistor (15) with its drain connected to the first terminal (40) of the capacitor (5) and with its source (14) connected to a second voltage source (E2) and measuring range adjusting means, which comprise a first voltage source (E1), connected to the base (9) of the transistor (8) and which comprise the second voltage source (E2), connected to the source (14) of the field effect transistor (15).

2. Peak detector circuit as claimed in claim 1, characterized in that, both measuring range means and reset-level means further comprise a voltage source (E4) connected to a terminal (24) of the voltage comparator circuit (3).

3. Peak detector circuit as claimed in claim 1, characterized in that, both measuring range adjusting means and reset-level means further comprise a voltage source (E3) connected via a resistor (34) to a first terminal (42) of a buffer (21), which is connected through a second terminal (41) to the first terminal (40) of the capacitor (5) and with its output to the output (6) of the peak detector circuit and a resistor (33) which is connected between the output of the buffer (21) and the first terminal (42) of the buffer (21) and whereby the resistor (34) is connected between the voltage source E3 and the first terminal (42) of the buffer (21).

4. Peak detector circuit as claimed in any of the preceding claims, characterized in that, the capacitor (5) tracks the positive going peaks or the negative going peaks of the input voltage.

**Patentansprüche**

1. Spitzendetektor mit einem Kondensator (5) als Speicherelement zum Speichern eines Spannungswerts, der ein Mass des Spitzenwerts einer an den Spitzendetektor zu legenden Eingangsspannung ist, mit einem Spannungskomparator (3) mit einem ersten Eingang (2) für die Eingangsspannung, einem zweiten an den Ausgang (6) des Spitzendetektors angeschlossenen zweiten Eingang (4) und weiter mit einem Transistor (8), dessen Kollektor (7) an einen ersten Anschluss (40) des Kondensators (5) und dessen Emitter (11) an den Ausgang des Komparators (3) angeschlossen ist, wobei zwischen der Basis (9) und dem Emitter (11) dieses Transistors (8) eine Diode (13) anti-parallel zur Basis-Emitter-Diode angeordnet ist, und weiter mit einem Rückstellschalter (15) zum Entladen des Kondensators (5) dadurch gekennzeichnet, dass der Spitzendetektor Pegelmittel enthält, die aus einem Feldeffekttransistor (15) besteht, dessen Drain an den ersten Anschluss (40) des Kondensators (5) und dessen Source (14) an eine zweite Spannungsquelle (E2) angeschlossen sind, und Messbereicheinstellmittel enthält, die aus einer ersten Spannungsquelle (E1) besteht, die an die Basis (9) des Transistors (8) angeschlossen ist, und weiter die zweite Spannungsquelle (E2) enthalten, die an die Source (14) des Feldeffekttransistors (15) angeschlossen ist.

2. Spitzendetektor nach Anspruch 1, dadurch gekennzeichnet, dass sowohl Messbereichmittel als auch Rückstellpegelmittel eine Spannungsquelle (E4) enthalten, die an einen Anschluss (24) des Spannungskomparators (3) angeschlossen ist.

3. Spitzendetektor nach Anspruch 1, dadurch gekennzeichnet, dass sowohl Messbereicheinstellmittel als auch Rückstellpegelmittel eine Spannungsquelle (E3), die über einen Widerstand (34) an einen ersten Anschluss (42) eines Pufferspeichers (21) angeschlossen ist, der über einen zweiten Anschluss (41) an den ersten Anschluss (40) des Kondensators (5) und dessen Ausgang an den Ausgang (6) des Spitzendetektors angeschlossen sind, und einen Widerstand (33) enthalten, der zwischen dem Ausgang des Pufferspeichers (21) und dem ersten Anschluss (42) des Pufferspeichers (21) angeschlossen ist, und wobei der Widerstand (34) zwischen der Spannungsquelle (E3) und dem ersten Anschluss (42) des Pufferspeichers (21) angeschlossen ist.

4. Spitzendetektor nach einem der vorangehenden Ansprüche, dadurch gekennzeichnet, dass der Kondensator (5) entweder den positiv gerichteten Spitzen oder den negativ gerichteten Spitzen der Eingangsspannung folgt.

**Revendications**

1. Circuit détecteur de crêtes comprenant un condensateur (5) comme élément de stockage pour stocker une valeur de tension qui est une mesure de la valeur de crête d'une tension d'entrée à appliquer au détecteur de crêtes, un circuit comparateur de tensions (3) comportant une première entrée (2) pour la tension d'entrée, une seconde entrée (5) couplée à la sortie (6) du circuit détecteur de crêtes et comprenant, en outre, un transistor (8), dont le collecteur (7) est couplé à une première borne (40) du condensateur (5) et l'émetteur (11), à la sortie du circuit comparateur (3), ce transistor (8) comportant, entre sa base (9) et l'émetteur (11), une diode (13) formant un montage antiparallèle avec la diode base-émetteur et comprenant, en outre, un commutateur de remise à l'état initial (15) pour décharger le condensateur (5), caractérisé en ce qu'il comporte des moyens pour le niveau de remise à l'état initial, qui comprennent un transistor à effet de champ (15) dont le drain est connecté à la première borne (40) du condensateur (5) et dont la source (14) est connectée à une seconde source de tension (E2) et des moyens de réglage de l'intervalle de mesure qui comprennent une première source de tension (E1), connectée à la base (9) du transistor (8) et qui comprennent la seconde source de tension (E2), connectée à la source (14) du transistor à effet de champ (15).

2. Circuit détecteur de crêtes suivant la revendication 1, caractérisé en ce que les moyens pour l'intervalle de mesure et pour le niveau de remise à l'état initial comprennent, en outre, une source de tension (E4) connectée à une borne (24) du circuit comparateur de tension (3).

3. Circuit détecteur de crêtes suivant la revendication 1, caractérisé en ce que les moyens de réglage de l'intervalle de mesure et les moyens pour le niveau de remise à l'état initial comprennent une source de tension (E2) connectée par l'intermédiaire d'une résistance (34) à une première borne (42) d'un tampon (21) qui est connecté par l'intermédiaire d'une seconde borne (41) à la première borne (40) du condensateur (5) et dont la sortie est connectée à la sortie (6) du circuit détecteur de crêtes et une résistance (33) qui est connectée entre la sortie du tampon (21) et la première borne (42) du tampon (21), cette résistance (34) étant connectée entre la source de tension (E3) et la première borne (42) du tampon (21).

4. Circuit détecteur de crêtes suivant l'une quelconque des revendications précédédentes, caractérisé en ce que le condensateur (5) suit les crêtes ascendantes ou les crêtes descendantes de la tension d'entrée.

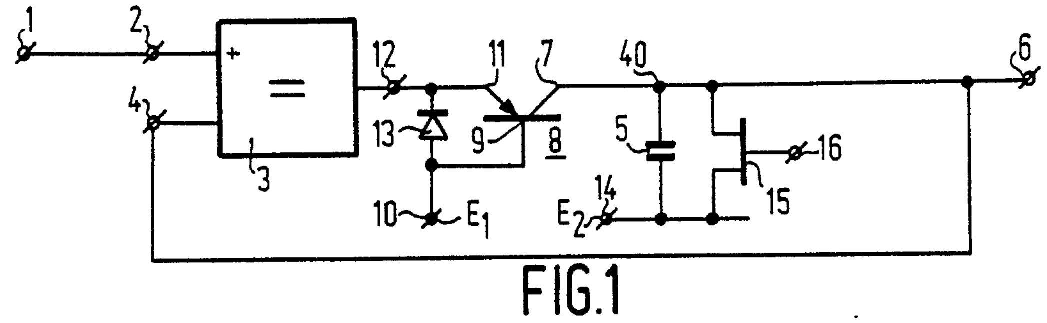


FIG.1

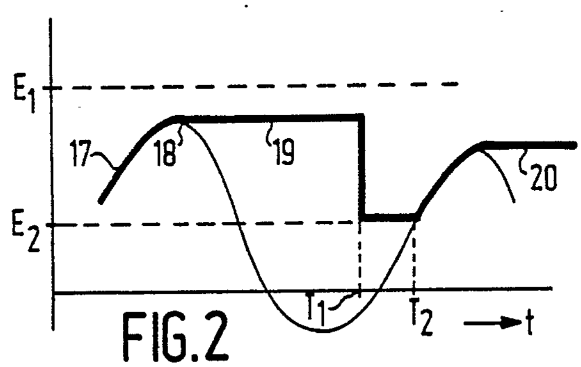


FIG.2

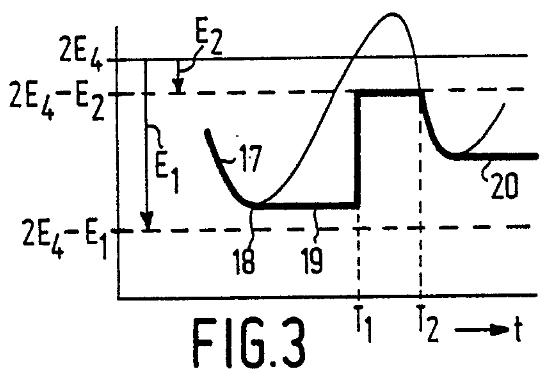


FIG.3

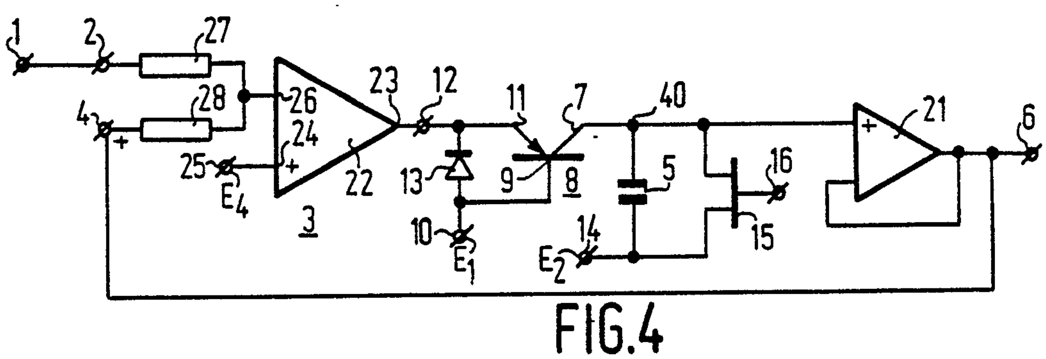


FIG.4

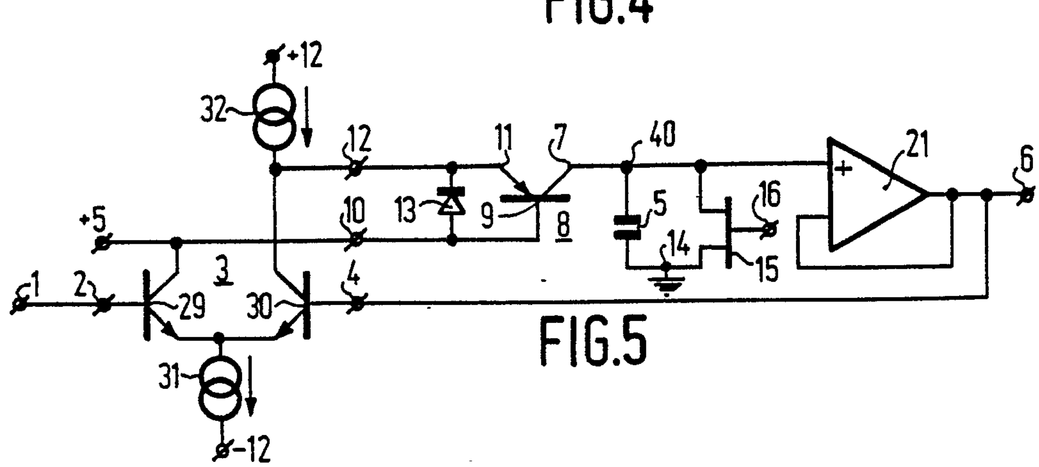


FIG.5

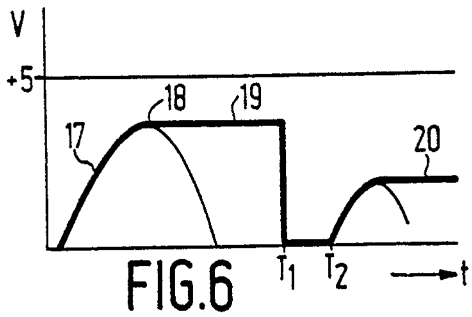


FIG.6

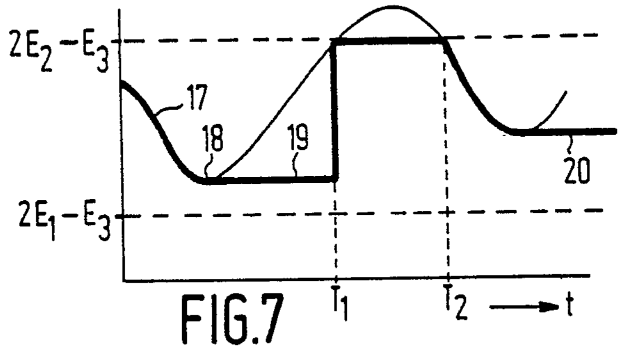


FIG.7

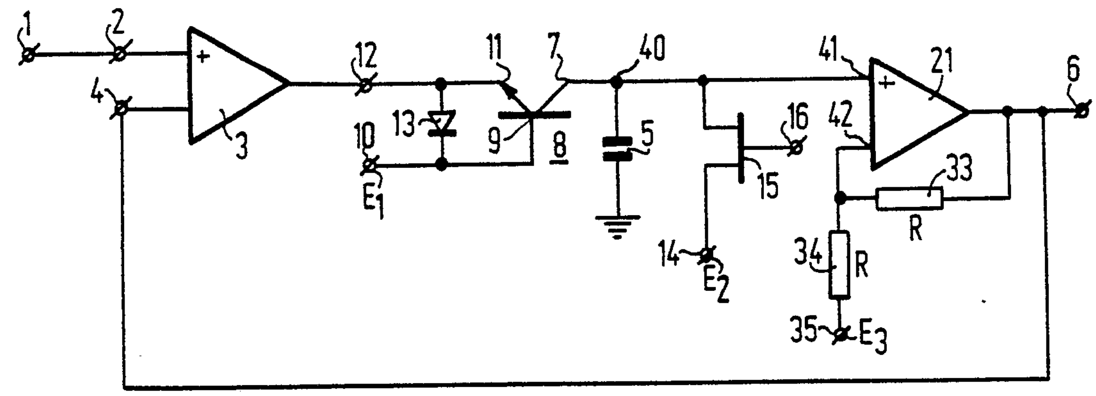


FIG.8

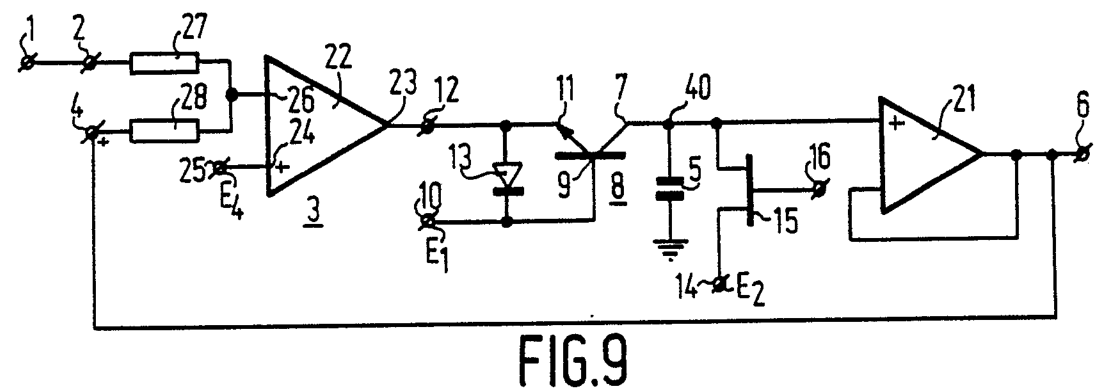


FIG.9

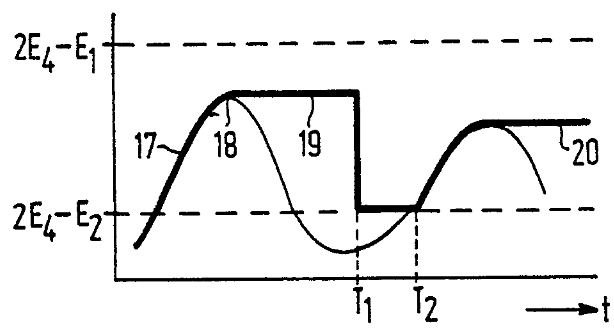


FIG.10